# EUROPEAN PATENT APPLICATION

(11) **EP 3 113 588 A1**
(43) Date of publication of application: **04.01.2017**
(21) Application number: 14891396.5
(22) Date of filing: 23.09.2014
(51) Int. Cl.: H05K 5/00, H05K 7/20

(54) **THERMAL CONTROL HOUSING**

(30) Priority: 09.05.2014 CN 201420239325 U
(71) Applicant: ZTE Corporation, Shenzhen, Guangdong 518057 (CN)
(72) Inventor: XU, Yongtian, Shenzhen Guangdong 518057 (CN); QIU, Tengyuan, Shenzhen Guangdong 518057 (CN); ZHANG, Mingming, Shenzhen Guangdong 518057 (CN)
(74) Representative: Novagraaf Technologies
(86) International application number: PCT/CN2014/087235
(87) International publication number: WO 2015/169032

(57) **Abstract**

Provided is a thermal control enclosure, which includes a lower shell (1); and an upper cover (2) mounted above the lower shell (1) in a fitting manner, wherein a thermal energy reflecting film (3) is adhered to (an) inner surface(s) of the lower shell (1) and/or the upper cover (2), and the thermal energy reflecting film is a reflective metal film. The thermal control enclosure is simple in structure and low in cost, and surface temperature of the enclosure may be effectively controlled.

## Description

### Technical Field

The present disclosure relates to the field of temperature control of electronic and communication equipment, and in particular to a thermal control enclosure usable for various kinds of electronic and communication equipment.

### Background

Along with heating of an electronic chip and power device in an enclosure of electronic and communication equipment and the like, surface temperature of the enclosure may rise, and particularly surface temperature of enclosure positions close to these heating components may be extraordinarily high. Excessive enclosure surface temperature may cause some problems: when an enclosure is stacked with other equipment for use, excessive surface temperature of the enclosure may directly increase temperature of the other equipment; and if surface temperature of an enclosure of household electronic equipment is excessively high, hands may be scalded by local high surface temperature of the enclosure when touching the enclosure.

### Summary

The embodiment of the present disclosure provides a thermal control enclosure, which radiates thermal radiation back into the enclosure through a thermal energy reflecting film adhered to an inner surface of the enclosure, thereby effectively controlling surface temperature of the enclosure.

In order to achieve the purpose of the present disclosure, the following technical solution is provided.

A thermal control enclosure may include: a lower shell; and an upper cover mounted above the lower shell in a fitting manner, wherein a thermal energy reflecting film may be adhered to (an) inner surface(s) of the lower shell and/or the upper cover.

Optionally, the thermal energy reflecting film may be a reflective metal film.

Optionally, the reflective metal film may be sprayed or coated or adhered to the inner surface(s) of the lower shell and/or the upper cover.

Optionally, the inner surface(s) of the lower shell and/or the upper cover may consist of a plurality of horizontal planes and non-horizontal planes at certain included angles with the horizontal planes.

Optionally, the non-horizontal planes may correspond to heating components. Optionally, the reflective metal film may be a copper film or an aluminum film. Beneficial effects of the present disclosure are embodied as follows:
1) in the present disclosure, the thermal energy reflecting film is adhered to the inner surface of the enclosure, and may reflect the heat radiation of the electronic components back into the enclosure, thereby reducing heat absorption of the enclosure and reducing the surface temperature of the enclosure;
2) the thermal energy reflecting film of the present disclosure adopts the reflective metal film, which not only may radiate the heat radiation back into the enclosure, but also may effectively extend the temperature due to high thermal conductivity of the reflective metal film, thereby making more uniform the surface temperature of the enclosure, eliminating local high-temperature hot points on a surface of the enclosure and effectively controlling the surface temperature of the enclosure; and
3) the inner surface of the enclosure of the present disclosure consists of the horizontal planes and the non-horizontal planes, the non-horizontal planes correspond to the heating components, and the non-horizontal planes reflect the heat radiation from the heating components to a no-heating-component area or heat-resistant area in the enclosure at certain reflecting angles to eliminate the local high-temperature hot points on the surface of the enclosure and effectively control the surface temperature of the enclosure.

### Brief Description of the Drawings

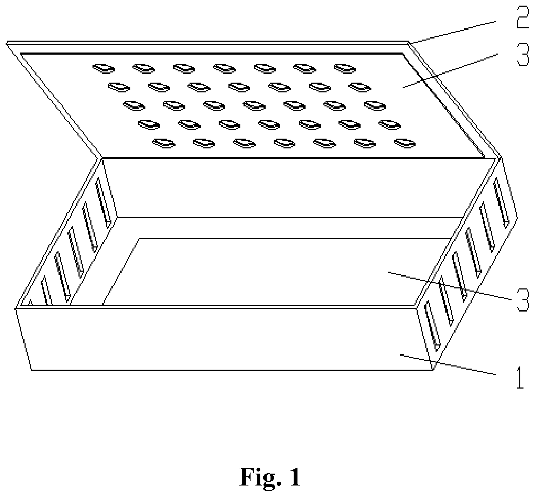

Fig. 1 is a structure diagram of a thermal control enclosure according to the present disclosure.

Descriptions about reference signs in the drawings: 1-lower shell; 2-upper cover; and 3-thermal energy reflecting film.

### Detailed Description of the Embodiments

As shown in Fig. 1, a thermal control enclosure includes: a lower shell 1; and an upper cover 2 mounted above the lower shell 1 in a fitting manner, wherein heating components are mounted in the enclosure.

At present, heating components in an enclosure may usually be cooled in three manners: heat conduction, convection and heat radiation. Gradual heating of the heating components may increase their heat radiation to a surface of the enclosure to cause rise of surface temperature of the enclosure, and particularly, local temperature of the enclosure close to positions of the heating components is higher.

In order to reduce the surface temperature of the enclosure, a thermal energy reflecting film 3 is adhered to an inner surface of the enclosure, and may reflect heat radiation of the electronic heating components back into the enclosure, thereby reducing heat absorption of the enclosure and reducing surface temperature of the enclosure; and thermal energy reflected back into the enclosure may be dissipated in another cooling manner such as heat conduction and convection.

During specific implementation, the thermal energy reflecting film 3 may be adhered to (an) inner surface(s) of the lower shell 1 and/or the upper cover 2 according to a practical requirement.

The thermal energy reflecting film 3 of the present disclosure Optionally adopts a reflective metal film, and the reflective metal film not only may radiate the heat radiation back into the enclosure, but also may effectively extend the temperature due to high thermal conductivity of the reflective metal film, thereby making more uniform the surface temperature of the enclosure, eliminating local high-temperature hot points on a surface of the enclosure and effectively controlling the surface temperature of the enclosure.

In addition, during specific design, the inner surface(s) of the lower shell 1 and/or the upper cover 2 may be designed to consist of a plurality of horizontal planes and a plurality of non-horizontal planes at certain included angles with the horizontal planes, and these non-horizontal planes may form certain reflecting angles and reflect the heat radiation from the heating components back into a no-heating-component area or heat-resistant area in the enclosure at the certain reflecting angles to eliminate the local high-temperature hot points on the surface of the enclosure and effectively control the surface temperature of the enclosure.

During specific operation, the non-horizontal planes correspond to the heating components, and the non-horizontal planes receive the heat radiation from the heating components and reflect the heat radiation from the heating components back into the no-heating-component area or heat-resistant area in the enclosure at the certain reflecting angles.

According to the thermal control enclosure of the present disclosure, temperature influence of the enclosure on other adjacent equipment may be effectively reduced, a probability of scalding a human body is also reduced, and safety of the electronic enclosure for the human body is improved.

The present disclosure is simple in structure, a manufacturing process is simple and flexible, and the reflective metal film may be sprayed or coated or adhered to the inner surface(s) of the lower shell 1 and/or the upper cover 2. Since copper or aluminum has higher thermal conductivity, the reflective metal film of the present disclosure Optionally adopts a copper film or an aluminum film. Specifically, the reflective metal film may be a metal thin film such as a copper foil or an aluminum foil, and is adhered to the inner surface of the enclosure in a gluing manner; and the reflective metal film may also be directly sprayed or coated on the inner surface of the enclosure in a manner of spraying, coating or the like.

The above is a detailed description about the present disclosure but not intended to limit the present disclosure, and those skilled in the art may make modifications according to a principle of the present disclosure. Therefore, various modifications made according to the principle of the present disclosure shall fall within the scope of protection of the present disclosure.

### Industrial Applicability

As mentioned above, the thermal control enclosure provided by the embodiment of the present disclosure has the following beneficial effects: the thermal energy reflecting film is adhered to the inner surface of the enclosure, and may reflect the heat radiation of the electronic components back into the enclosure, thereby reducing heat absorption of the enclosure and reducing the surface temperature of the enclosure; the thermal energy reflecting film adopts the reflective metal film, which not only may radiate the heat radiation back into the enclosure, but also may effectively extend the temperature due to high thermal conductivity of the reflective metal film, thereby making more uniform the surface temperature of the enclosure, eliminating the local high-temperature hot points on the surface of the enclosure and effectively controlling the surface temperature of the enclosure; and the inner surface of the enclosure consists of the horizontal planes and the non-horizontal planes, the non-horizontal planes correspond to the heating components, and the non-horizontal planes reflect the heat radiation from the heating components to the no-heating-component area or heat-resistant area in the enclosure at the certain reflecting angles to eliminate the local high-temperature hot points on the surface of the enclosure and effectively control the surface temperature of the enclosure.

## Claims

1. A thermal control enclosure, comprising:
a lower shell; and
an upper cover mounted on the lower shell; wherein
a thermal energy reflecting film is adhered to (an) inner surface(s) of the lower shell and/or the upper cover.

2. The thermal control enclosure according to claim 1, wherein the thermal energy reflecting film is a reflective metal film.

3. The thermal control enclosure according to claim 2, wherein the reflective metal film is sprayed or coated or adhered to the inner surface(s) of the lower shell and/or the upper cover.

4. The thermal control enclosure according to claim 3, wherein the inner surface(s) of the lower shell and/or the upper cover consist(s) of a plurality of horizontal planes and non-horizontal planes at certain included angles with the horizontal planes.

5. The thermal control enclosure according to claim 4, wherein the non-horizontal planes correspond to heating components.

6. The thermal control enclosure according to claim 5, wherein the reflective metal film is a copper film or an aluminum film.
